(19) **Europäisches Patentamt**

**European Patent Office**

**Office européen des brevets**

(11) **EP 1 035 582 A2**

(12) **EUROPEAN PATENT APPLICATION**

(43) Date of publication:
**13.09.2000 Bulletin 2000/37**

(51) Int. Cl.⁷: **H01L 23/522**, H01L 21/762

(21) Application number: **00104468.4**

(22) Date of filing: **08.03.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **08.03.1999 JP 6071799**

(71) Applicant:
**KABUSHIKI KAISHA TOSHIBA**
**Kawasaki-shi, Kanagawa-ken 210-8520 (JP)**

(72) Inventors:
• **Kanda, Yasuo,**
  **c/o Toshiba Corporation**
  **Tokyo (JP)**
• **Suzuki, Hidenori**
  **c/o Toshiba Corporation**
  **Tokyo (JP)**

(74) Representative: **HOFFMANN - EITLE**
**Patent- und Rechtsanwälte**
**Arabellastrasse 4**
**81925 München (DE)**

(54) **Semiconductor device and method of manufacturing the same**

(57) A semiconductor device comprises at least element isolation regions 102 arranged on a main surface of a semiconductor substrate 100, one element region arranged on the main surface of the semiconductor substrate 100 to be surrounded by the element isolation insulating film 102, a gate electrode wiring 108b formed on the element isolation insulating film 102, and a gate electrode wiring108a formed over the element region via a gate insulating film 106. The coupling capacitance can be reduced by setting heights of the gate electrode wirings 108a and 108b substantially equally to thus reduce their opposing area. Also, the leakage current flowing between the gate electrode 108b and the semiconductor substrate 100 can be suppressed by forming the element isolation insulating film 102 to have a convex shape from the main surface of the semiconductor substrate 100.

FIG.3

## Description

Cross Reference to Related Applications

The subject application is related to subject matter disclosed in the Japanese Patent Application No. Hei 11-60717 filed in March 8, 1999 in Japan, to which the subject application claims priority under the Paris Convention and which is incorporated by reference herein.

Background of the Invention

1. Field of the Invention

The present invention relates to a structure of a semiconductor device and a method of manufacturing the same. More particularly, the present invention relates to a structure of a miniaturized semiconductor device and a method of manufacturing the same.

2. Description of the Related Art

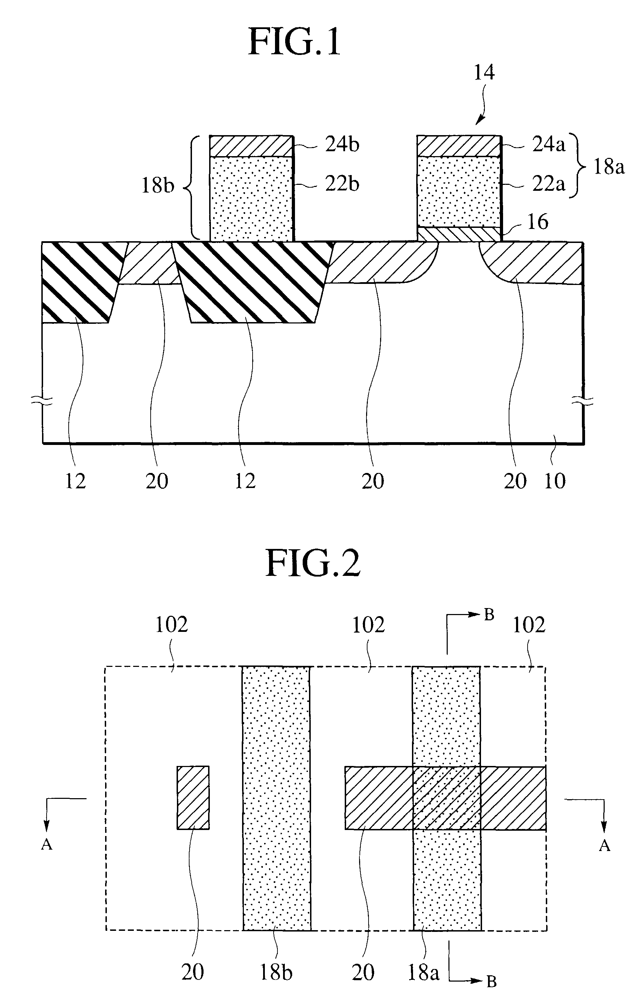

FIG.1 is a sectional view showing a structure of a normal semiconductor device. As shown in FIG.1, in this semiconductor device, element isolation insulating films 12 are buried on a main surface of a semiconductor substrate 10, and a MOS transistor 14 is formed in a element region on the main surface surrounded by the element isolation insulating films 12. This element isolation method is called an STI (Shallow Trench Isolation) method. The MOS transistor 14 comprises a gate electrode wiring 18a formed on the main surface of the semiconductor substrate 10 via a gate insulating film 16, and high impurity concentration semiconductor regions 20 formed on the main surface of the semiconductor substrate 10, acting as source-drain diffusion layers. The gate electrode wiring 18a has a polycide structure in which a ploysilicon film 22a is arranged as an underlying layer and a silicide film 24a is arranged as an overlying layer. The characteristic of the MOS transistor 14 is decided by the ploysilicon film 22a. Accordingly, if respective thicknesses of the ploysilicon film 22a and the silicide film 24a are adjusted, a resistance of the gate electrode wiring 18a can be reduced until a resistance of the silicide film 24a becomes dominant.

In the semiconductor device in FIG.1, a gate electrode wiring 18b of another MOS transistor (not shown) is arranged on the element isolation insulating film 12 in vicinity of the gate electrode wiring 18a. Also, the main surface of the semiconductor substrate 10 is planarized, so that a thickness of the gate electrode wiring 18b on the element isolation insulating film 12 becomes substantially equal to a thickness of the gate electrode wiring 18a on the element region.

With the higher capacity and the miniaturization of the semiconductor device, a distance between neighboring gate electrode wirings is reduced more and more, and therefore a capacitance between the gate electrode wirings is increased more and more. Particularly, in DRAM (Dynamic Random Access Memory), sometimes the gate electrode wiring is also used as a word line. In this case, if the distance between the gate electrode wirings is narrowed, a capacitance between the word lines of neighboring bits (coupling capacitance) is extremely increased. Therefore, the influence of the coupling upon the data in the neighboring bit (coupling noise) caused when one bit data is shifted is very increased and thus there is such a possibility that the malfunction is caused.

Also, a leakage current between the gate electrode wiring on the element isolation insulating film and the semiconductor substrate poses a weighty problem.

Summary of the Invention

The present invention has been made to overcome such subject and it is an object of the present invention to provide a semiconductor device which can reduce a coupling capacity and suppress a leakage current.

It is another object of the present invention to provide a method of manufacturing a semiconductor device which can reduce a coupling capacity and suppress a leakage current.

In order to overcome the above subject, according to a first aspect of the present invention, there is provided a semiconductor device comprising: (a) a semiconductor substrate; (b) a plurality of element isolation regions formed on a main surface of the semiconductor substrate, each element isolation region having a convex shape from the main surface of the semiconductor substrate; (c) an element region formed on the main surface of the semiconductor substrate and enclosed by the element isolation regions; (d) a first wiring arranged over the element region; and(e) a second wiring arranged over the element isolation region, a height of the second wiring from the main surface of the semiconductor substrate being substantially equal to a height of the first wiring from the main surface of the semiconductor substrate.

In the first aspect of the present invention, more particularly, as a shape of the element isolation region, a part thereof is buried in a trench formed on the main surface of the substrate and remaining portions are projected from the main surface of the semiconductor substrate.

According to the first aspect of the present invention, it is possible to set heights of the first wiring on the element region and the second wiring on the element isolation regions from the main surface of the semiconductor substrate to be substantially equal to each other by forming the element isolation region as a convex shape protruded from the main surface of the semiconductor substrate. Therefore, the opposing area between the first wiring and the second wiring can be reduced. The coupling capacitance between the first wiring and the second wiring can be reduced because of reduction of the opposing area, and therefore the malfunction of the semiconductor device due to the coupling noise can be prevented.

According to the first aspect of the present invention, the element isolation region becomes thick by an amount of projection from the main surface of the semiconductor substrate rather than the prior art and therefore the leakage current flowing between the first wiring on the element isolation region and the semiconductor substrate can be suppressed.

In the first aspect of the present invention, a wiring resistance can be made small if the first and second wirings are formed as the polycide structure. In addition, the silicide having the polycide structure is formed of a refractory metal silicide, for example. The refractory metal is formed of Mo, W, Ta, Ti, etc.

According to a second aspect of the present invention, there is provided a semiconductor device comprising: (a) a semiconductor substrate; (b) a plurality of element isolation regions formed on a main surface of the semiconductor substrate, each element isolation region having a convex shape from the main surface of the semiconductor substrate; (c) an element region formed on the main surface of the semiconductor substrate and enclosed by the element isolation regions;(d) a MOS transistor formed on the element region; (e) a first gate electrode wiring constituting a gate electrode of the MOS transistor; and (f) a second gate electrode wiring disposed on the element isolation region, a height of the second gate electrode wiring from the main surface of the semiconductor substrate being substantially equal to a height of the first gate electrode wiring from the main surface of the semiconductor substrate.

The second aspect of the present invention shows an example in which the semiconductor device according to the first embodiment is applied to the DRAM. According to the second aspect of the present invention, the same advantages as the first embodiment can be achieved.

According to a third aspect of the present invention, there is provided a method of manufacturing a semiconductor device, comprising the steps of: (a) forming a first film on a main surface of a semiconductor substrate; (b) forming a trench on the main surface of the semiconductor substrate to pass through the first film; (c) depositing a second film on the main surface of a semiconductor substrate to bury the trench completely; (d) selectively removing the second film to be left only in the trench; (e) forming a plurality of element isolation regions which has a convex shape from the main surface of the semiconductor substrate and at least one element region which is enclosed by the element isolation regions, by removing the first film remaining in the main surface of a semiconductor substrate; (f) forming a gate electrode constituting material film on the main surface of the semiconductor substrate containing the element isolation regions and the element region; (g) planarizing the gate electrode constituting material film; and (h) forming simultaneously a first gate electrode wiring which is arranged over at least the element region and a second gate electrode wiring which is arranged over at least the element isolation regions, by patterning the gate electrode constituting material film.

According to the third aspect of the present invention, the semiconductor device which can achieve the above advantages can be easily fabricated.

Other and further objects and features of the present invention will become obvious upon an understanding of the illustrative embodiments about to be described in connection with the accompanying drawings or will be indicated in the appended claims, and various advantages not referred to herein will occur to one skilled in the art upon employing of the invention in practice.

Brief Description of the Drawings

FIG.1 is a sectional view showing a structure of a normal semiconductor device having an STI structure;
FIG.2 is a plan view showing a structure of a semiconductor device according to a first embodiment of the present invention;
FIG.3 is a sectional view taken along a line A-A in FIG.1;
FIG.4 is a sectional view taken along a line B-B in FIG.1;
FIGS.5A to 5J are sectional views showing a method of manufacturing a semiconductor device according to the first embodiment of the present invention; and
FIG.6 is a sectional view showing a structure of a semiconductor device according to a second embodiment of the present invention.

Description of the Preferred Embodiments

Various embodiments of the present invention will be described with reference to the accompanying drawings. In the drawings, the same or similar reference numerals are applied to the same or similar parts and elements. However, it is to be noted that the drawings are only diagrammatic and the relation between thicknesses and plane dimensions, a ratio of thickness of each layer and the like are different from those of actual cases. Thus, the actual thickness and dimension should be judged by considering the following explanations. Also, it is natural that the portions in which the ratio and the relation between the respective dimensions are different between the respective drawings are included

(First Embodiment)

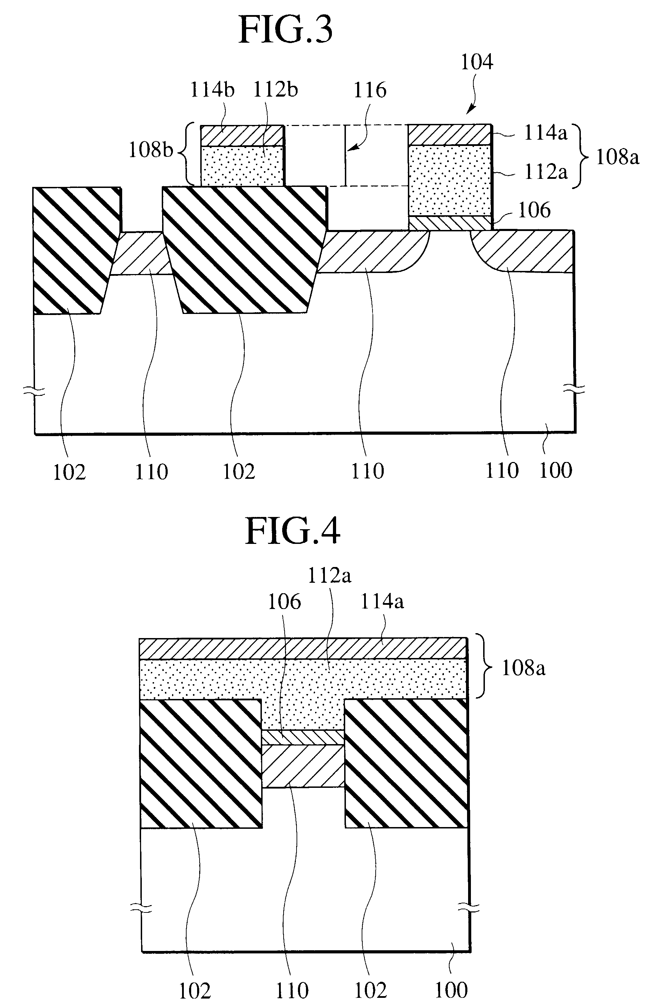

FIG.2 is a plan view showing a structure of a semiconductor device according to a first embodiment of the present invention. FIG.3 is a sectional view taken along a line A-A in FIG.1. FIG.4 is a sectional view taken along a line B-B in FIG.1. As shown in FIG.3, in a semiconductor device according to the first embodiment of the present invention, element isolation insulating films 102 are buried on a main surface of a semiconductor substrate 100, and a MOS transistor 104 is formed in a element region on the main surface surrounded by the element isolation insulating films 102. The MOS transistor 104 comprises a gate electrode wiring 108a formed on the main surface of the semiconductor substrate 100 via a gate insulating film 106, and high impurity concentration semiconductor regions 110 formed on the main surface of the semiconductor substrate 100, serving as source-drain diffusion layers. The gate electrode wiring 108a has a polycide structure in which a ploysilicon film 112a is arranged as an underlying layer and a suicide film 114a such as refractory metal, etc. is arranged as an overlying layer. As the polycide structure, normally MoSi2/polySi, Wsi2/polySi, TaSi2/polySi, TiSi2/polySi, etc. are employed. The characteristic of the MOS transistor 104 is decided by the underlying ploysilicon film 112a. Therefore, if respective thicknesses of the ploysilicon film 112a and the silicide film 114a are adjusted, a resistance of the gate electrode wiring 108a can be reduced until a resistance of the silicide film 114a becomes dominant.

In the semiconductor device according to the first embodiment of the present invention, a gate electrode wiring 108b of another MOS transistor is arranged on the element isolation insulating film 102 in vicinity of the gate electrode wiring 108a. Also, a part of the element isolation insulating film 102 is buried in the semiconductor substrate 100, while remaining portion is projected from a surface of the semiconductor substrate 100 to from a convex shape. Also, the gate electrode wiring 108b on the element isolation insulating film 102 and the gate electrode wiring 108a on the element region are different in thickness to reduce their opposing area 116 as small as possible. In FIG.3, a total film thickness of the gate electrode wiring 108b is reduced by reducing the film thickness of the ploysilicon film 112a. As described above, resistances of the gate electrode wirings 108a and 108b are decided substantially by the silicide films 114a and 114b. For this reason, the resistance of the gate electrode wiring 108b is never largely increased even if the silicide film 114b is reduced in thickness.

In the semiconductor device according to the first embodiment of the present invention, since the gate electrode wiring 108b on the element isolation insulating film 102 and the gate electrode wiring 108a on the element region are formed differently in thickness to make their surface heights almost equal, the opposing area between the neighboring gate electrode wirings 108a and 108b can be reduced. As a result, the coupling capacitance area between the neighboring gate electrode wirings can be reduced rather than the semiconductor device in FIG.1.

The element isolation insulating film 102 is sufficiently thick rather than the element isolation insulating film 12 in FIG.1. Accordingly, the leakage current flowing between the gate electrode wiring 108b and the semiconductor substrate 100 can be reduced.

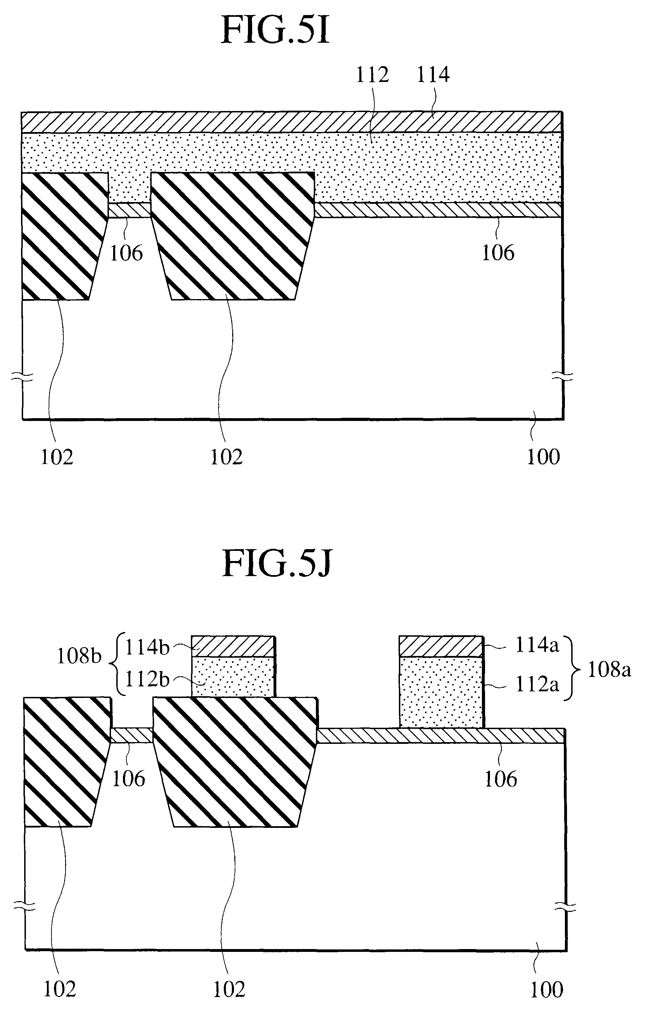

Next, a method of manufacturing a semiconductor device according to the first embodiment of the present invention will be explained with reference to FIG.3 and FIGS.5A to 5J hereinafter.

(A) As shown in FIG.5A, a silicon oxide film ($SiO_2$) 118 of about 8 nm thickness is formed by oxidizing the semiconductor substrate 100 in the oxidizing atmosphere. Then, a silicon nitride film ($Si_3N_4$) 120 of about 92 nm thickness is formed on the silicon oxide film 118 by the CVD (Chemical Vapor Deposition) method.

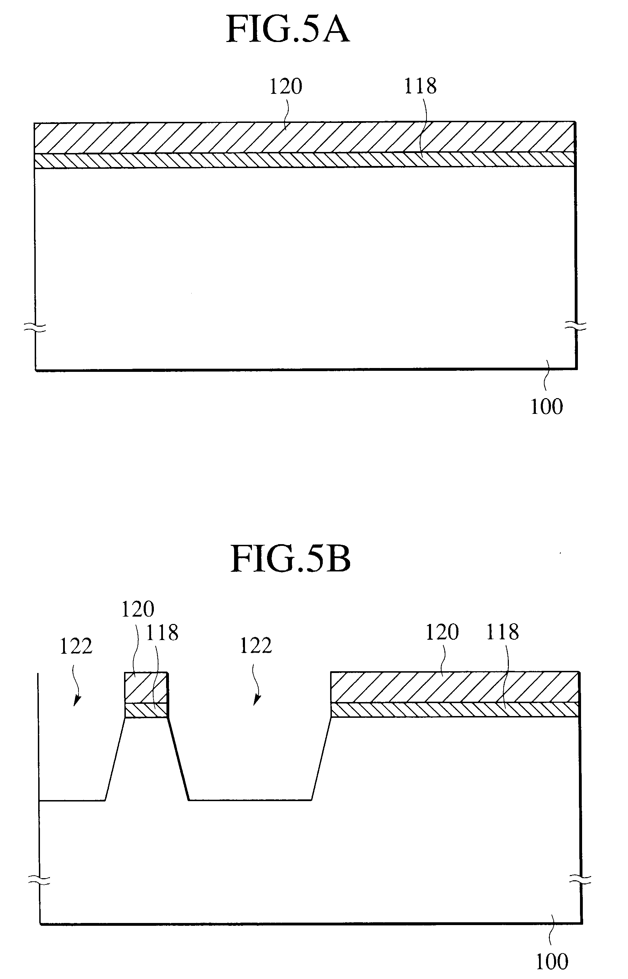

(B) As shown in FIG.5B, a trench 122 of at least about 100 nm depth is formed in a region of the semiconductor substrate 100, in which the element isolation insulating film 102 is formed, by the well-known exposure technology and the etching technology. In order to form the trench 122, either the dry etching using the RIE (Reactive Ion Etching) or the wet etching using the etchant may be employed.

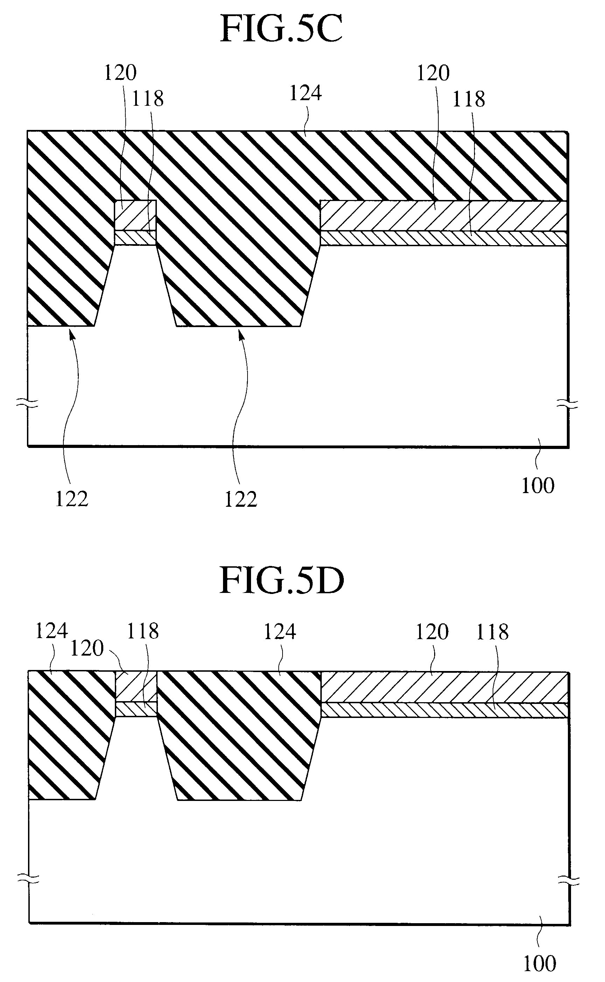

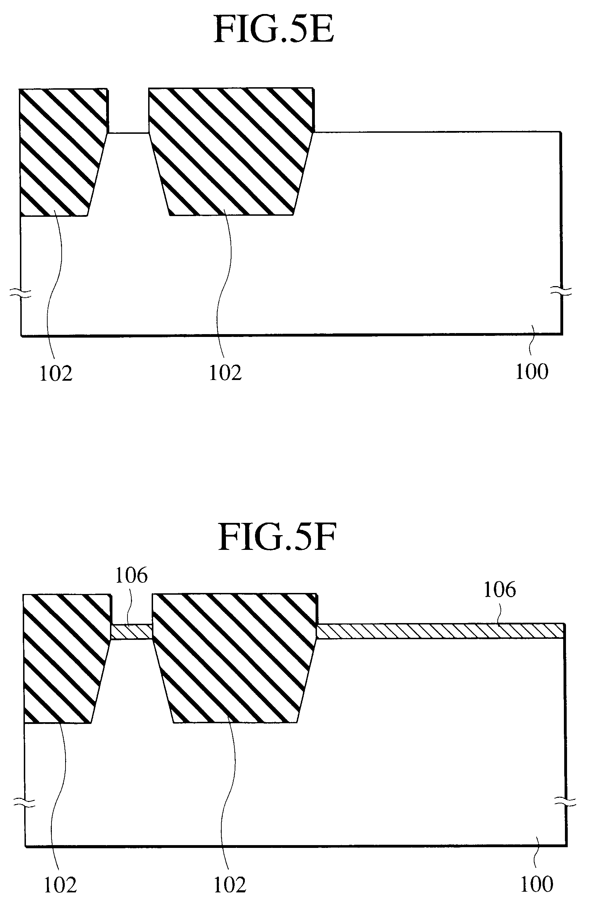

(C) As shown in FIG.5C, an oxide film 124 is deposited by the CVD method to bury the trench 122 completely. The CVD oxide film 124 is formed to have a film thickness of at least about 100 nm on the silicon nitride film 120. As the CVD oxide film 124, for example, a TEOS (Tetraethylorthosilicate) oxide film may be employed. This is because the TEOS oxide film has excellent burying property to provide a high throughput. Of course, material to be buried in the trench 122 is not limited to the TEOS oxide film. For example, any dielectric material such as the polysilicon film may be employed.

(D) As shown in FIG.5D, after the CVD oxide film 124 has been formed, the CVD oxide film 124 in the element region is removed by the CMP (Chemical-Mechanical Polishing) method and then the main surface of the semiconductor substrate 100 is planarized.

(E) As shown in FIG.5E, the silicon oxide film 118 and the silicon nitride film 120 in the element region are removed such that the convex element isolation insulating film 102 is formed to project from the surface of the semiconductor substrate 100.

(F) As shown in FIG.5F, after the cleaning process prior to predetermined gate oxidation, the semiconductor substrate 100 is oxidized at the temperature of about 1000°C to form the gate insulating film 106 of about 8 nm thickness. In this case, the gate insulating film 106 is not formed on the element isolation insulating film 102 because such element isolation insulating film 102 is a very thick oxide film.

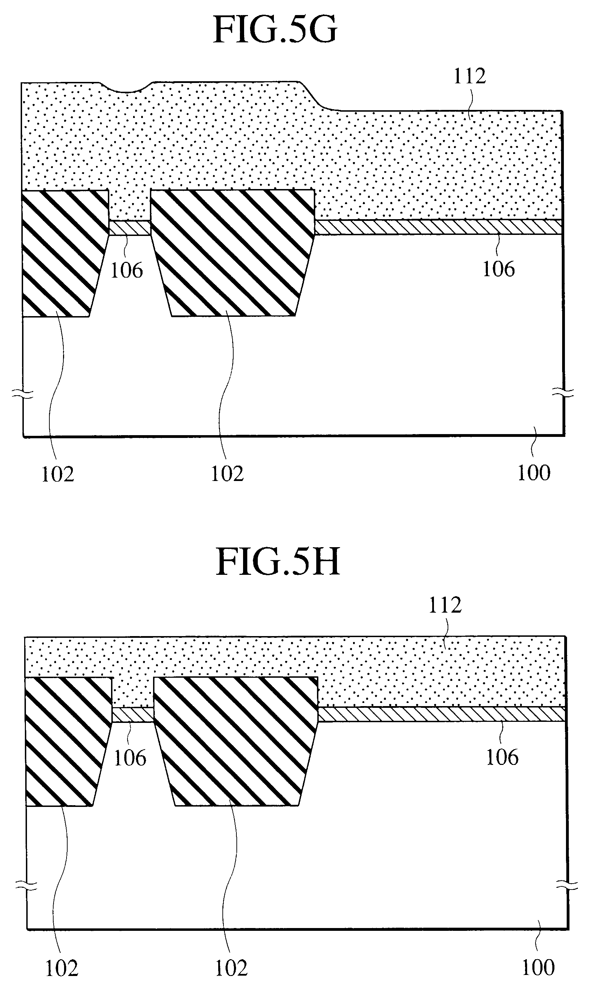

(G) As shown in FIG.5G, after the gate insulating film 106 has been formed, the polysilicon film 112 is deposited on the main surface of the semiconductor substrate 100. This the polysilicon film 112 is deposited to have a thickness of about 150 to 200 nm.

(H) As shown in FIG.5H, the surface of the polysilicon film 112 is planarized by the CMP method.

(I) As shown in FIG.5I, after the planarization of the polysilicon film 112 has been completed, the silicide film 114 of about 50 nm thickness is deposited on the polysilicon film 112. This silicide film 114 is formed of a refractory silicide film such as tungsten silicide ($WSi_2$) deposited by the CVD method or the sputter method.

(J) As shown in FIG.5J, the gate electrode wirings 108a and 108b are formed on the main surface of the semiconductor substrate 100. The gate electrode wirings 108a and 108b are formed by patterning using the exposure technology and the dry etching technology.

(K) After the impurity is implanted by the ion implantation technology, the high impurity concentration semiconductor regions 110 are formed by executing the annealing process to activate the impurity, whereby the semiconductor device shown in FIG.3 is completed. Although not shown, after the semiconductor device shown in FIG.3 has been completed, an interlayer oxide film which is formed of a phosphorus glass film such as PSG (Phosphosilicate glass), BPSG (Borophosphosilicate glass), etc. is deposited over the MOS transistor 104 on an overall surface of the semiconductor substrate 100 by the CVD method. Since the gate electrode wiring 108b on the element isolation insulating film 102 is set substantially equal in height to the gate electrode wiring 108a on the element region, planarization of the interlayer oxide film can be improved rather than the case in FIG.1. After the interlayer oxide film has been deposited, a connection hole is opened in the interlayer oxide film by the exposure technology and the dry etching technology, and then a wiring layer is deposited by the sputter method. Aluminum (Al) is popular as the wiring metal, but copper (Cu) is also employed recently. Then, the wiring layer is patterned by the exposure technology and the dry etching technology. Finally, a resultant structure is covered with a passivation film which is formed of a nitride film formed by the plasma CVD method, whereby the final semiconductor device is completed. The coupling capacitance of the semiconductor device manufactured as above can be reduced up to about 70 % of the semiconductor device shown in FIG.1.

(Second Embodiment)

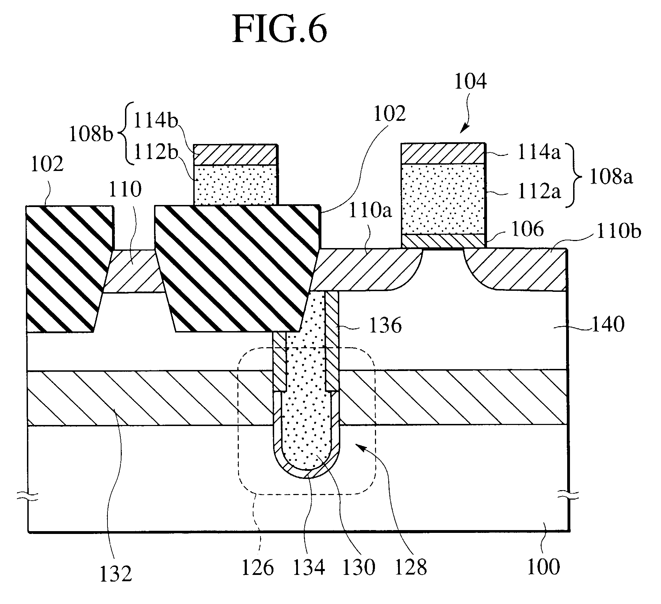

Next, a second embodiment of the present invention will be explained hereunder. FIG.6 is a sectional view showing a structure of a semiconductor device according to the second embodiment of the present invention. The second embodiment of the present invention shows an example in which the semiconductor device according to the first embodiment is applied to a trench capacitor cell of the DRAM.

As shown in FIG.6, in the trench capacitor cell according to the second embodiment of the present invention, a storage capacitor 126 is arranged three-dimensionally. More particularly, the storage capacitor 126 is formed deeply in the semiconductor substrate 100. One electrode of the storage capacitor 126 is formed of a buried polysilicon film 130 buried in a trench 128, the other electrode is formed of a high impurity concentration region 132 formed in the semiconductor substrate 100. Also, a capacitor insulating film 134 of the storage capacitor 126 is formed of an ON (Oxide/Nitride) film having a high dielectric constant. A well 140 formed on the high impurity concentration region 132 (or the semiconductor substrate 100 if the well structure is not provided) and the buried polysilicon film 130 are isolated by an oxide film 136. As the capacitor insulating film 134, a nitride laminated layer such as an ONO (Oxide/Nitride/Oxide) film, etc. may be employed in addition to the ON film. If the oxide film and the nitride film are constructed as the laminated structure, the capacitor insulating film which has low defect density and high reliability can be achieved while using the high dielectric constant of the nitride film positively.

In the second embodiment of the present invention, the MOS transistor 104 acts as a transfer gate of the memory cell of DRAM. The MOS transistor 104 connects electrically the high impurity concentration semiconductor region 110a to the buried polysilicon film 130. Then, at the time of ON operation, the charge stored in the storage capacitor 126 is output onto a data line (called also a bit line) (not shown) connected to the high impurity concentration semiconductor region 110b.

According to the second embodiment of the present invention, like the first embodiment, the coupling capacitance can be reduced. Also, since the element isolation insulating film 102 is formed sufficiently thick rather than the prior art, the leakage current flowing between the gate electrode wiring 108b passing through the element isolation insulating film 102 and the storage capacitor 134 can be reduced.

(Other Embodiment)

As described above, the present invention has been set forth in the first and second embodiments.

But it should not be understood that the discussion and the drawings constituting a part of this disclosure are interpreted to limit the present invention. It is apparent for the skilled person that various alternatives, modifications, and the practices can be achieved based on this disclosure.

For example, in the first and second embodiments of the present invention, the coupling capacitance can be reduced by providing the difference in thickness between the neighboring gate electrode wirings to reduce the opposing area. However, it is evident from the above technical concept that, if the present invention is applied to the aluminum wiring on the interlayer oxide film, the similar advantages can be achieved.

In addition, in the above second embodiment, the trench capacitor cell of DRAM is shown as an example. However, it is of course that a stacked capacitor may be employed as the storage capacitor.

In this manner, it should be understood that the present invention contains various embodiments not set forth herein. Accordingly, the present invention is only restricted only by indispensable matters of the present invention set forth in claims based on appropriately this disclosure.

**Claims**

1. A semiconductor device comprising:

   (a) a semiconductor substrate;
   (b) a plurality of element isolation regions formed on a main surface of the semiconductor substrate, each element isolation region having a convex shape from the main surface of the semiconductor substrate;
   (c) an element region formed on the main surface of the semiconductor substrate and enclosed by the element isolation regions;
   (d) a first wiring disposed on the element region; and
   (e) a second wiring disposed on the element isolation region, a height of the second wiring from the main surface of the semiconductor substrate being substantially equal to that of the first wiring from the main surface of the semiconductor.

2. A semiconductor device according to claim 1, wherein a thickness T1 of the first wiring, a thickness T2 of the second wiring, and a thickness T3 of the element isolation region, which are projected from the main surface of the semiconductor substrate, have a following substantial relationship

   $$T1=T2+T3.$$

3. A semiconductor device according to claim 1, wherein the element isolation region has a trench structure formed on the main surface of the semiconductor substrate.

4. A semiconductor device according to claim 3, wherein the element isolation region is composed of a first layer buried in the trench and a second layer projected from the main surface of the semiconductor substrate.

5. A semiconductor device according to claim 4, wherein the first layer and the second layer are formed integrally.

6. A semiconductor device according to claim 5, wherein the first layer and the second layer are formed of dielectric material.

7. A semiconductor device according to claim 1, wherein the first layer and the second layer constitute gate electrodes of two MOS transistors.

8. A semiconductor device according to claim 7, wherein the first layer and the second layer have a polycide structure which includes a polysilicon film as an underlying layer and a silicide film as an overlying layer.

9. A semiconductor device according to claim 8, wherein the silicide is a refractory metal silicide.

10. A semiconductor device according to claim 9, wherein the refractory metal is any one of Mo, W, Ta, and Ti.

11. A semiconductor device comprising:

    (a) a semiconductor substrate;
    (b) a plurality of element isolation regions formed on a main surface of the semiconductor substrate, each element isolation region having a convex shape from the main surface of the semiconductor substrate;
    (c) an element region formed on the main surface of the semiconductor substrate and enclosed by the element isolation regions;
    (d) a MOS transistor formed on the element region;
    (e) a first gate electrode wiring constituting a gate electrode of the MOS transistor; and
    (f) a second gate electrode wiring disposed on the element isolation region, a height of the second gate electrode wiring from the main surface of the semiconductor substrate being substantially equal to that of the first gate electrode wiring form the main surface of the semiconductor substrate.

**12.** A semiconductor device according to claim 11, further comprising a storage capacity for holding charges, and wherein an electrode of the storage capacity is connected electrically to one of source and drain diffusion layers of the MOS transistor.

**13.** A semiconductor device according to claim 12, wherein the storage capacitor is a trench capacitor.

**14.** A semiconductor device according to claim 12, wherein the storage capacitor is either a stacked capacitor.

**15.** A method of manufacturing a semiconductor device, comprising the steps of:

(a) forming a first film on a main surface of a semiconductor substrate;
(b) forming a trench on the main surface of the semiconductor substrate to pass through the first film;
(c) depositing a second film on the main surface of a semiconductor substrate to bury the trench completely;
(d) selectively removing the second film to be left only in the trench;
(e) forming a plurality of element isolation regions which has a convex shape from the main surface of the semiconductor substrate and at least one element region which is enclosed by the element isolation regions, by removing the first film remaining in the main surface of a semiconductor substrate;
(f) forming a gate electrode constituting material film on the main surface of the semiconductor substrate containing the element isolation regions and the element region;
(g) planarizing the gate electrode constituting material film; and
(h) forming simultaneously a first gate electrode wiring which is disposed on the element region and a second gate electrode wiring which is disposed on the element isolation regions, by patterning the gate electrode constituting material film.

**16.** A method of manufacturing a semiconductor device according to claim 15, wherein the step of removing the second film includes the step of polishing the second film by a chemical-mechanical polishing method.

**17.** A method of manufacturing a semiconductor device according to claim 15, wherein the step of planarizing the gate electrode constituting material film includes the step of polishing the gate electrode constituting material film by a chemical-mechanical polishing method.

# FIG.1

# FIG.2

# FIG.3

# FIG.4

# FIG.5A

120     118

100

# FIG.5B

122     120     118     122     120     118

100

# FIG.5C

120    120    124    120    118
      118

122    122    100

# FIG.5D

124    118    124    120    118
   120

100

# FIG.5E

102    102    100

# FIG.5F

106    106

102    102    100

# FIG.5G

112

106

106

102    102    100

# FIG.5H

112

106

106

102    102    100

# FIG.5I

112  114

106

106

102  102  100

# FIG.5J

108b { 114b  112b

108a } 114a  112a

106

106

102  102  100

# FIG.6